# EUROPEAN PATENT APPLICATION

(11) **EP 4 614 820 A1**
(43) Date of publication of application: **10.09.2025**
(21) Application number: 25159439.6
(22) Date of filing: 21.02.2025
(51) Int. Cl.: H04B 5/45, H04B 5/79

(54) **NFC CONTROLLER**

(30) Priority: 04.03.2024 FR 2402153
(71) Applicant: STMicroelectronics International N.V., 1228 Plan-les-Ouates, Geneva (CH)
(72) Inventor: CORDIER, Nicolas, 13080 AIX-EN-PROVENCE (FR); SAKURAI, Hiroki, TOKYO, 145-0065 (JP)
(74) Representative: Cabinet Beaumont

(57) **Abstract**

The present disclosure relates to an NFC controller (140) configured to switch from active load modulation to passive load modulation at least when a received signal strength indicator (RSSI) becomes higher than a first RSSI threshold.

## Description

### Technical field

The present disclosure relates generally to NFC controllers (Near Field Communication) and their related functioning methods.

### Background art

NFC devices are used worldwide. They must therefore comply with diverse norms and use cases.

### Summary of Invention

There is a need to provide NFC devices comprising NFC controllers complying with the maximum of international standards and use cases.

One embodiment addresses all or some of the drawbacks of known NFC controllers.

One embodiment provides an NFC controller configured to switch from active load modulation to passive load modulation at least when a received signal strength indicator becomes higher than a first RSSI threshold.

One embodiment provides an NFC controller configured to switch from active load modulation to passive load modulation at least when a battery power level is lower than a first power threshold or when an NFC charging session starts.

One embodiment provides a method of operating an NFC controller, comprising the step of switching from active load modulation to passive load modulation at least when a battery power level is lower than a first power threshold or when an NFC charging session starts.

According to an embodiment, the controller switches from passive load modulation to active load modulation when a received signal strength indicator becomes higher than a first RSSI threshold.

According to an embodiment, the controller switches from active load modulation to passive load modulation when the received signal strength indicator becomes lower than a second RSSI threshold, the first RSSI threshold being higher than the second threshold.

According to an embodiment, the controller switches from passive load modulation to active load modulation when the battery power level is higher than a second power threshold.

According to an embodiment, the first and second RSSI thresholds are based on the modulation type.

According to an embodiment, the switching is performed when the controller is in a card emulation mode.

According to an embodiment, the received signal strength indicator is filtered or averaged.

According to an embodiment, the controller comprises at least one resistive circuit and, during passive load modulation, said resistive circuit is configured to adopt a first or a second resistance value based on a load modulation signal level.

According to an embodiment, the controller comprises at least one radio frequency driver and, during passive load modulation, said radio frequency driver is configured to adopt a third or a fourth resistance value based on the load modulation signal level.

According to an embodiment, said at least one resistive circuit has a plurality of first branches in parallel each coupling ground to a same first node, each first branches comprising a first switch and a resistor ; and
- said at least one radio frequency driver comprising a plurality of second branches coupling ground to a reference voltage rail, each of the second branches comprising:
   an NMOS and a PMOS transistors in series, a conduction node of said NMOS transistor being coupled to ground and a conduction node of said PMOS transistor being coupled to the reference voltage rail, a conduction node common to said NMOS transistor and said PMOS transistor being coupled to a second node ;
   a second switch configured to couple, in a first state, a controlling node of said PMOS transistor to the reference voltage rail and, in a second state, the controlling node of said PMOS and NMOS transistors to a same third node; and
   a third switch configured to couple, in a first state, a controlling node of said NMOS transistor to ground, and in a second state, the controlling node of said PMOS and NMOS transistors to the third node, the first state of the second and third switches occurring at the same time, and the second state of the second and third switches occurring at the same time.

According to an embodiment, the first and second resistance values correspond respectively to a first number of the first switches of the first branches being in a conductive state and to a second number of the first switches of the first branches being in a conductive state; the first switches of the resistive circuit being driven based on the load modulation signal level, a first load modulation signal level corresponding to said first number and a second load modulation signal level corresponding to said second number.

According to an embodiment, the third and fourth resistance values correspond respectively to a third and fourth numbers of the second or third switches of the second branches which are in the first state, the first load modulation signal level corresponding to said third number and the second load modulation signal level corresponding to said fourth number.

According to an embodiment, during active load modulation, the resistive circuit is configured to adopt, based on a damping signal level:
a fifth resistance value adapted to lower a quality factor of an antenna coupled to the controller; and
a sixth resistance value adapted to increase said quality factor;
said fifth and sixth resistance values corresponding to a respective fifth and sixth number of first switches of the first branches which are in a conductive state.

According to an embodiment, the controller comprises a first logic unit configured to perform, during active load modulation, an AND logic function from an NFC carrier signal and the load modulation signal, to generate a control signal on the third node.

According to an embodiment, the load modulation signal is a Manchester coded subcarrier of the NFC carrier signal.

According to an embodiment, the NMOS or PMOS transistors of the second branches are binary weighted from one second branch to another and wherein the resistors of the first branches are binary weighted from one first branch to another.

According to an embodiment, the first, second, third, fourth, fifth and sixth numbers are coded in one or several registers of a non-volatile memory.

According to an embodiment, the controller comprises a first and a second of said at least one resistive circuits, and a first and a second of said at least one radio frequency driver;
the controller comprising a second logic unit configured to perform, during active load modulation, an AND logic function from the inversed NFC carrier signal and the load modulation signal, to generate an inversed control signal on the third node coupled to the second radio frequency driver.

One embodiment provides an NFC device comprising:
- the NFC controller as described above;
- an antenna; and
- a matching circuit coupling the controller to the antenna.

According to an embodiment, the matching circuit comprises:
- a first and a second input nodes coupled respectively to the first and second resistive circuits of the controller;
- a third and fourth input nodes coupled respectively to the first and the second radio frequency drivers of the controller ;
- a first and a second output nodes coupled to the antenna;
- a first and a second capacitance coupling respectively the first input node to the first output node and the second input node to the second output node;
- a third capacitance coupling the first output node to the second output node;
- a resistor coupling the first output node to the second output node;
- a first and a second inductances coupling respectively the first radio frequency driver to a fourth node and the second radio frequency driver to a fifth node;
- a fourth and a fifth capacitances coupling respectively the fourth node and the fifth node to ground;
- a sixth and a seventh capacitances coupling respectively the fourth node to the first output node and the fifth node to the second output node.

### Brief description of drawings

The foregoing features and advantages, as well as others, will be described in detail in the following description of specific embodiments given by way of illustration and not limitation with reference to the accompanying drawings, in which:
Figure 1 represents a very schematic view of a NFC system to which the embodiments apply;
Figure 2 represents schematically circuits of the NFC system according to an embodiment;
Figure 3 represents schematically circuits of the NFC system according to an embodiment ;
Figure 4 represents schematically a circuit of Figure 2 according to an embodiment;
Figure 5 represents schematically a circuit of Figure 3 according to an embodiment;
Figure 6 is a chronogram of functioning of the circuits of Figure 3;
Figure 7 is another chronogram of functioning of a circuit of Figure 3; and
Figure 8 is another chronogram of functioning of a circuit of Figure 3.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

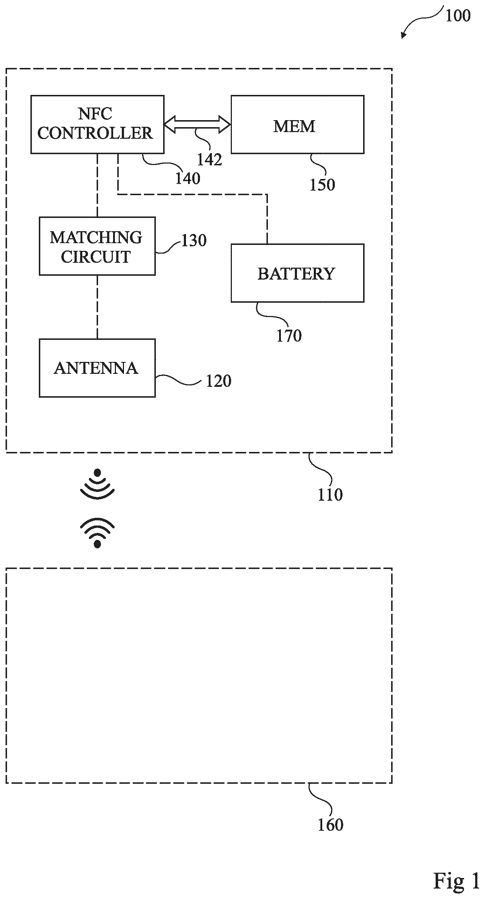

Figure 1 represents a very schematic view of a NFC system 100.

The NFC system 100 comprises a first NFC device 110 which is able to communicate with a second NFC device 160.

NFC or in other words near field communication systems use a radio frequency electromagnetic field generated by the second device (terminal or reader) 160 to communicate with the other device (card) 110. The same device can, particularly with regard to mobile telephones, operate in reader mode by generating a field intended for another device, or in card mode by capturing a field generated by another device. This technology concerns the establishment of very short distance communications (less than ten centimeters) between two devices.

This NFC technology also allows an NFC device to charge one or more other NFC devices placed nearby.

In the present description, we consider the case of a system in which the NFC devices are compatible with the NFC technology according to the NFC Forum.

In the example of Figure 1, the NFC device 110 comprises a matching circuit 130 (MATCHING CIRCUIT) coupling an antenna 120 (ANTENNA) to an NFC controller 140 (NFC CONTROLLER) .

The NFC controller 140 is for example furthermore coupled to a memory 150 (MEM), e.g. a non-volatile memory, via a communication bus 142. The memory for example comprises registers to store configurations of the NFC controller 140.

The NFC device 110 is for example a phone or a smartphone emulated in card mode or a card with a battery 170 coupled to the NFC controller 140.

In an example, the NFC device 110 is compatible with the norm ISO 14443A/B and/or FeliCA also known as JIS.X.6319-4.

This allows information to be exchanged between the contactless reader and secure elements located in the NFC device 110 for example. Numerous applications are thus possible, such as mobile ticketing for public transport (the mobile telephone acting as a transport ticket) or mobile payment (the mobile telephone acting as a payment card).

During a transmission of information between a reader 160 and an object in card - or tag- emulation mode, the reader generates a magnetic field via its antenna, which is generally a sinusoidal wave at 13.56 MHz in the standards that are conventionally used.

Two modes of operation are possible, a passive modulation mode or an active modulation mode. In the passive mode, only the reader generates the magnetic field and the object 110, in card (or tag) emulation mode, is then passive and acts as the target.

More specifically, the antenna 120 emulating the ticket or the card modulates the field generated by the reader 160.

This modulation is performed by modifying the load connected to the terminals of the antenna 120 of the first NFC device 110.

By modifying the load at the terminals of the antenna 120, the output impedance of the antenna of the reader 160 changes due to the magnetic coupling between the two antennas. This results in a change in the amplitudes and/or the phases of the voltages and currents that are present in the antennas of the reader and of the object.

Thus, in this way, the information to be transmitted from the object to the reader is transmitted, by load modulation, to the antenna currents of the reader.

The load variation performed in the load modulation is reflected in an amplitude modulation and/or phase modulation of the signal (voltage or current) at the antenna of the reader. A copy of the antenna current is generated and injected into the reception chain of the reader, where this current is demodulated and processed to extract the transmitted information.

In the active modulation mode of operation, the reader 160, and the first NFC device 110 in card emulation mode, both generate an electromagnetic field. Generally, this operating mode is used when the NFC device 110 is provided with its own power source, for example the battery 170, as is the case with a cellular mobile telephone, which is then in card-emulation mode.

Each of the NFC devices transmits data using a modulation scheme, for example an OOK (On-Off-keying) amplitude-modulation scheme.

In this case, the modulation is reflected by a load modification, and reference is then made to communication through active load modulation.

In comparison with a passive load modulation, greater operating distances are obtained, which may range as far as 10 cm depending on the protocol that is used.

Moreover, the use of active load modulation makes it possible to use small antennas. However, this type of communication by active load modulation presents other drawbacks.

It is desirable, when communicating by active load modulation, for the signal transmitted by the device in card-emulation mode to be in phase, or in phase opposition, with the signal received from the reader to have, at the reader and hence also at the device in card emulation mode, a modulation amplitude that is as large as possible in terms of absolute value. A phase adjustment is generally needed on the device in card emulation mode during the development of the device in a known environment which is not always feasible.

Moreover, in active load modulation, a calibration is needed to synchronize the local oscillator of the card emulator to the reader signal. This process needs several milliseconds to be accurate enough to pass the phase drift requirement of the norm ISO144443 for example.

However, in the transport sector, the object in card emulation mode must be able to operate with old readers of limited performance, such as those with only envelope-detection reception architecture, different from the architectures having two channels. Moreover, many readers used for access control in several countries are not compliant with all the specifications of the norm ISO144443 and the startup time in these cases can be reduced down to 30µs and enabling first commands for example 177 µs after starting their radiofrequency magnetic field.

An example of envelope-detector readers are readers which may implement the Felica protocol. It has been found that the distance between such envelope-detector readers and the object in card-emulation mode influences the coupling effect, in particular when this distance is small, for example smaller than 50 mm, which results in a mismatch in the reader-object system, and hence introduces a phase shift between the signal received by the reader and the signal transmitted by the object or vice versa. This phase shift can be in either direction depending on the use case and become important enough to be incompatible with some standards.

There is therefore a need to find a solution to overcome this phase shift when the distances between the reader 160 and the emulated card mode device 110 becomes smaller than 50 mm.

Moreover, the active modulation requires power from the battery 170 which may cause functioning issues in the case of a low battery level.

The disclosed embodiments provide an NFC controller 140 configured to switch from active load modulation to passive load modulation at least when the battery power level is lower than a first power threshold or when an NFC charging session starts.

In an example, the NFC controller switches from passive load modulation to active load modulation when the battery power level is higher than a second power threshold.

These embodiments allow to maintain a basic operation state of the device 110 even if the battery is low. Moreover, it allows the charge of a depleted battery by forcing passive load modulation at a low battery level and initiate an NFC wireless charging session.

Other embodiments provide that the controller switches from passive load modulation to active load modulation when the received signal strength indicator (RSSI) becomes higher than a first RSSI threshold or that the controller switches from active load modulation to passive load modulation when the received signal strength indicator becomes lower than a second RSSI threshold, the first RSSI threshold being higher than the second threshold.

The received signal strength indicator is here used to approximate the distance between the reader and the NFC device 110, and figure out when phase shifting would possibly happen due to close coupling. Since passive load modulation has much shorter response time than active load modulation, this improves interoperability and performances by shortening the response time and preventing phase degradation in close coupling. This also creates a hysteresis to prevent a parasitic switch between the passive load modulation and the active modulation mode due to received signal strength indicator variations around the first or the second RSSI threshold.

In an example, the first and second RSSI thresholds are based on the modulation type.

In another example, the switching is performed when the controller is in a card emulation mode.

In another case, the received signal strength indicator is filtered or averaged. This helps to prevent a parasitic switch between the passive load modulation and the active modulation mode due to the received signal strength indicator variations.

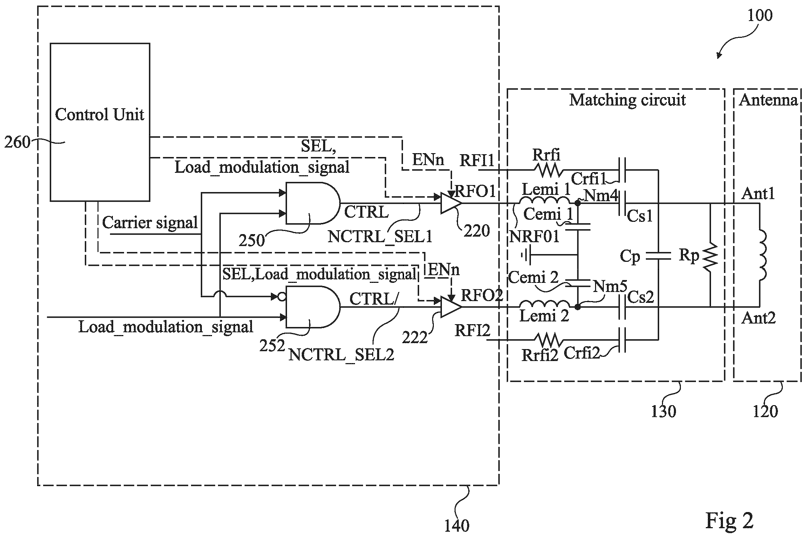

Figure 2 represents schematically circuits of the NFC system 100 according to an embodiment. More precisely, Figure 2 represents the NFC controller 140, the matching circuit 130 and the antenna 120 of the NFC device 110. The NFC controller 140 represented allows to switch between passive load modulation and active load modulation.

In the represented antenna, the antenna 120 is coupling a node Ant1 to a node Ant2.

In the represented example, the matching circuit 130 is comprising two input nodes NRF01, NRF02, a first capacitance Cp coupling the first output node Ant1 to the second output node Ant2; and a resistor Rp coupling the first output node Ant1 to the second output node Ant2. In the matching circuit 130 represented, a first and a second inductances Lemi1, Lemi2 are coupling respectively the node NRF01 to a node Nm4 and the node NRF02 to a node Nm5; a second and a third capacitances Cemi1, Cemi2 are respectively coupling the nodes Nm4 and Nm5 to ground. Additionally, a fourth and a fifth capacitances Cs1,Cs2 are coupling respectively the node Nm4 to the first output node Ant1 and the node Nm5 to the second output node Ant2. Furthermore, a capacitance Crfi1 and a resistance Rrfi1 are connected in series between a node RFI1 and the first output node Ant1. Another capacitance Crfi2 and another resistance Rrfi2 are connected in series between a node RFI2 and the second output node Ant2. The nodes RFI1 and RFI2 are configured to receive, in card emulation mode, the signal sent by the reader via the antenna 120 and, in reader mode, the load modulation signal generated by the contactless tag or card coupled to the antenna 120.

The NFC controller 140 also comprises two radio frequency drivers 220,222.

The load modulation signal is for example a Manchester coded subcarrier of the NFC 13,56 MHz frequency.

In the represented example, the radio frequency driver 220 are coupling a node NCTRL _SEL1 to the node NRF01 of the matching circuit 130 and the radio frequency driver 222 couples a node NCTRL _SEL2 to the node NRF02 of the matching circuit 130.

The radio frequency drivers 220,222 are moreover configured to receive n setting signals ENn, the load modulation signal, a selection signal SEL, and respectively a first and a second control signal CTRL, CTRL/. The first and second control signal CTRL, CTRL/, are configured to be sent on the node NCTRL _SEL1 and on the node NCTRL_SEL2 respectively. The selection signal SEL is also configured to be sent on the node NCTRL_SEL1 and on the node NCTRL _SEL2. The selection signal SEL and the n setting signals ENn are for example issued by a control unit 260 (Control Unit) of the NFC controller.

In the represented example, the NFC controller comprises a first and a second logic units 250,252 configured to perform, during active load modulation, respectively: an AND logic function from an NFC carrier signal and the load modulation signal to generate the first control signal CTRL on the node NCTRL_SEL1; and an AND logic function from the inversed (i.e. shifted by 180°) NFC carrier signal and the load modulation signal, to generate the second control signal CTRL/ on the node NCTRL_SEL2.

During passive load modulation, the radio frequency drivers 220,222 are configured to adopt a third or a fourth resistance values based on the load modulation signal level. The n setting signals ENn as well as the selection signal SEL set the third and fourth values. The n setting signals ENn and the selection signal are for example based on instructions bits which are stored, through registers, in the memory 150. When the load modulation signal corresponds to an unloaded state, the radio frequency drivers 220,222 are set to the third resistance value, and when the load modulation signal corresponds to a loaded state, the radio frequency drivers 220,222 are set to the fourth resistance value. The fourth resistance value is for example lower than one Ohm and the third value is set to a high impedance.

During active load modulation, the radio frequency drivers 220,222 exhibit one ON-resistance value which is based on the signals ENn. The signal on nodes NRF01 or NRF02 is alternatively pushed to a reference voltage VDD, also called VDDRF, then pulled to ground according to the respective control signals CTRL or CTRL/.

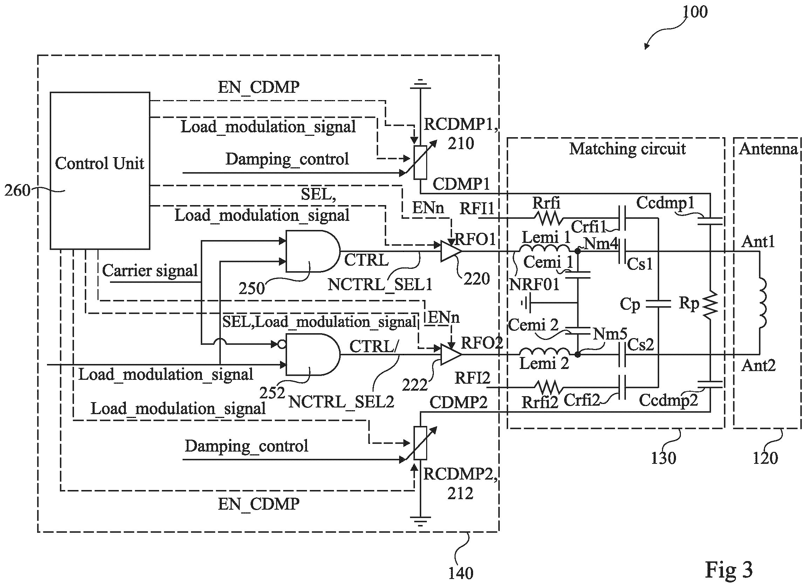

Figure 3 represents schematically circuits of the NFC system 100 according to an embodiment.

The example of Figure 3 comprises the circuit of Figure 2 to which components are added.

In the represented example, the matching circuit 130 is comprising other input nodes CDMP1, CDMP2 and a first and a second capacitance Ccdmp1, Ccdmp2 coupling respectively the node CDMP1 to the first output node Ant1 and the input node CDMP2 to the second output node Ant2. The NFC controller 140 is also comprising two resistive circuits 210,212 (RCDMP1, RCDMP2) coupling ground respectively to the node CDMP1 and to node CDMP2.

The resistive circuits 210,212 are configured to receive, each, resistance configuration signals (EN_CDMP), a load modulation signal (Load_modulation_signal) and a damping control signal (Damping_control). A first and a second resistance values of the resistive circuits 210,212 are for example set by the resistance configuration signals (EN_CDMP). The first and second resistance values are for example coded and stored, through registers, in the memory 150.

In an example, during passive load modulation, the resistance value of the resistive circuits 210,212 toggles between the first and the second resistance values depending on the load modulation signal level. The second resistance value is for example lower than one Ohm and the first value is set to a high impedance. In an example, when the load modulation signal corresponds to an unloaded state, the resistive circuits 210,212 are set to the first resistance value, and when the load modulation signal corresponds to a loaded state, the resistive circuits 210,212 are set to the second resistance value.

In another example, during active load modulation, the resistance value of the resistive circuits 210,212 toggles between a fifth and a sixth resistance values (equal or different from first and second resistances values) depending on the damping control signal. In this example, the fifth resistance value is set for example high enough to decrease the quality factor of the antenna 120 and therefore damp an active load modulation signal enabling resynchronization of an internal phase locked loop to the reader 160 signal. The sixth resistance value is for example low enough to ensure a high-quality factor of the antenna 120 during resynchronization with the reader signal and active load modulation transmission.

The example of Figure 3 provides an additional way to realize passive load modulation by either switching between two predefined resistance values of the drivers 220,222, as in Figure 2, and/or by switching between two predefined resistances values of the resistive circuits 210,212.

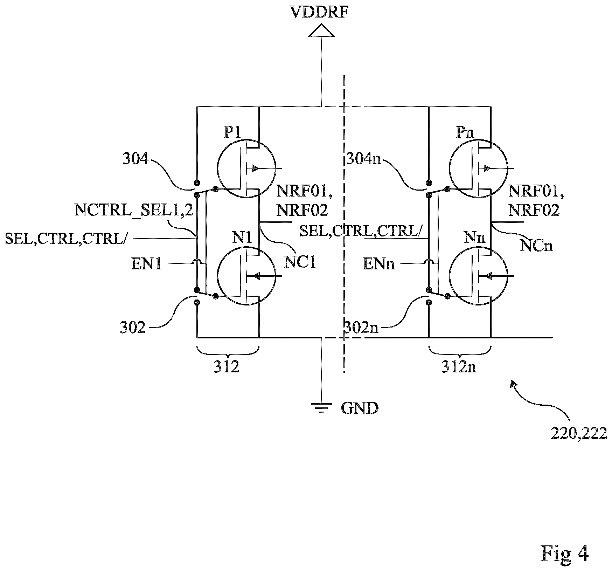

Figure 4 represents schematically a circuit of Figure 2 or 3 according to an embodiment. More precisely, Figure 4 represents examples of the radio frequency drivers 220,222.

The radio frequency drivers 220,222 of Figure 3 are for example comprising N (N being an integer) branches 312...312n coupling ground to a reference voltage rail VDD.

Each of the branches 312...312n is comprising an NMOS N1...Nn and a PMOS P1...Pn transistors in series. A conduction node of the NMOS transistor is coupled to ground and a conduction node of the PMOS transistor is coupled to the VDD voltage rail. A conduction node NC1...NCn, which is common to the NMOS transistor and the PMOS transistor of the respective branch, is coupled to the node NRFO1 (respectively NRF02 for the second radio frequency driver 222). In an example, the PMOS and NMOS transistors have a different size from one branch to the other. For example, their ON-resistance is binary weighted i.e. is twice the value as compared to the one of the previous branch.

Each of the branches 312...312n is furthermore comprising a switch 302...302n and another switch 304...304n.

The switch 302...302n, of each respective branch, is coupling, in a first state, the controlling node of the PMOS transistor P1...Pn to the VDD voltage rail and, in a second state, the controlling node of the PMOS and NMOS N1...Nn transistors to the node NCTRL _SEL1 (respectively NCTRL_SEL2 for the radio frequency driver 222).

The switch 304...304n, of each respective branch, is coupling, in a first state, the controlling node of the NMOS transistor to ground, and in a second state, the controlling node of the PMOS and NMOS transistors to the node NCTRL_SEL1 (respectively NCTRL_SEL2). In an example, the first state of the switches 302...302n and switches 304...304n is occurring at the same time, and the second state of the switches 302...302n and another switch 304...304n are occurring at the same time. The first and second states are controlled by the respective signals EN1...ENn.

During passive loading modulation, the selection signal SEL is connected to the controlling nodes of the NMOS and PMOS transistors of all the branches 312...312n. If the signal SEL is similar to VDD (or VDDRF) then the PMOS transistors impedance is high and NMOS transistors are turned on, i.e. they are in a conducting state. The NMOS transistors are therefore selected. If the signal SEL is similar to ground, the PMOS transistors are selected. In other words, the SEL signal selects either the NMOS lines or the PMOS lines. The SEL signal depends for example to a bit stored in the memory 150. On the other hand, when the signals En1...ENn turn the switches 302...302n and 304...304n in their first state, it turns off the transistors P1...P1n and N1...N1n, i.e. it turns off the respective branch which becomes non-conductive. The signals En1...ENn selects which branches among the branches 312...312n are selected. According to the number of branches selected, the resistance of the radio frequency drivers 220,222 can be modified. The first and second resistances can be thus predefined and coded on N bits (for example N=8 bits). In an example, the code 0xFF means that the branches are ON which would correspond to the loaded state and the code 0x00 means that all branches are disconnected which place the radio frequency drivers 220,222 in a high impedance state which would correspond to the unloaded state. The configuration bits corresponding to the given resistances are for example stored in the memory 150. The person of the art can choose other codes to implement other resistance values for the loaded and unloaded states of the load modulation signal.

During active load modulation, the branches of the drivers 220,222 consist in push-pull stages (for example eight stages if N=8). Each push-pull stage is the pair of the PMOS and NMOS transistors P1...Pn, N1...N1n of the same branch which alternatively push the output on node NRF01 (respectively NRF02) to VDD (VDDRF) potential and pull it to the ground potential. The signals EN1...ENn enable which of the push-pull stage is possibly controlled by the signal CTRL (respectively CTRL/). Deactivated push-pull stages are high impedance. The idle state of the CTRL and CTRL/ signals can adopt three configurable configurations. Both can be high, both low or one high and one low.

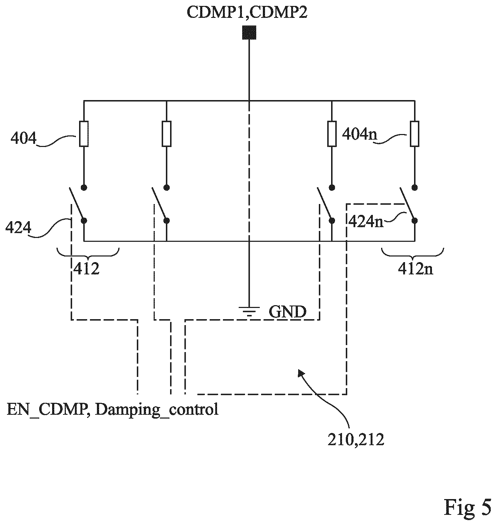

Figure 5 represents schematically a circuit of Figure 3 according to an embodiment. More precisely, Figure 5 represents an embodiment of the resistive circuits 210,212.

In the represented example, the resistive circuits 210,212 have N branches 412...412n in parallel each coupling ground to the node CDMP1 (respectively CDMP2).

Each branch 412...412n is comprising a switch 424...424n and a resistor 404...404n which has for example a different and binary weighted resistance value from one branch to another. The switches 424...424n are for example transistors.

In active modulation, the switches 424...424n are selectively enabled, following a damping signal (Damping_control), to define at least two resistances values for example coded on N bits. According to which of the switches 424...424n are in a conducting state (depending on the Nth bit value), the resistance of the resistive circuit is low or on the contrary of high impedance. The obtained resistance is called damping resistance and is used to decrease the quality factor of the antenna 120 and therefore damp an active load modulation signal enabling resynchronization of an internal phase locked loop to the reader 160 signal.

During passive load modulation, at least two resistances are for example predefined by the resistance configuration signals EN_CDMP. The load modulation signal allows toggling between at least two of the predefined resistance values coded on N bits. For example, if the code is 0x3FF, all branches 412...412n are in a conducting state, which leads to resistance value of the resistive circuit for example as low as 0,3 Ohms used during loaded (otherwise said modulated) state of the load modulation signal. If the code is 0x000, all branches 412...412n are in a non-conducting state which leads to a high impedance used during the unloaded (otherwise said unmodulated) state of the load modulation signal. The person of the art can choose which switches to be selected to obtain different resistances values.

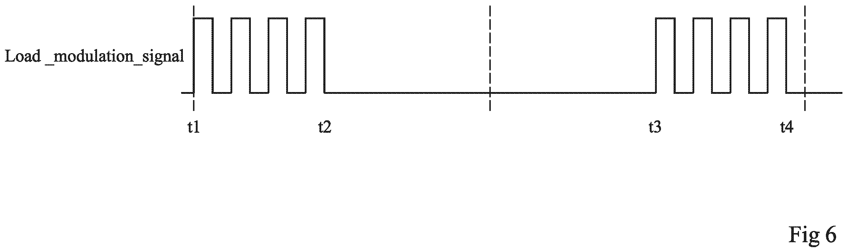

Figure 6 is a chronogram of functioning of the circuits of Figure 3. More precisely, Figure 6 represents the load modulation signal as function of time when emulating a contactless card compliant with the ISO14443-A protocol at the basic rate of 106kbps.

In the represented example, between a time t1 and a time t2 and further between a time t3 and a time t4, the load modulation signal, which is a Manchester coded subcarrier of the NFC signal, exhibit two times four pulses between a low and a high state. The high state corresponds to a loaded state (or modulated state) and the low state corresponds to an unloaded state (or unmodulated state). During said loaded state, a predefined resistance of the resistive circuits 210,212 or of the radio frequency drivers 220,222 is set, and during the unloaded state another predefined resistance value is set. It allows to perform a passive load modulation using the same resistive circuits and radio frequency drivers as for the active load modulation.

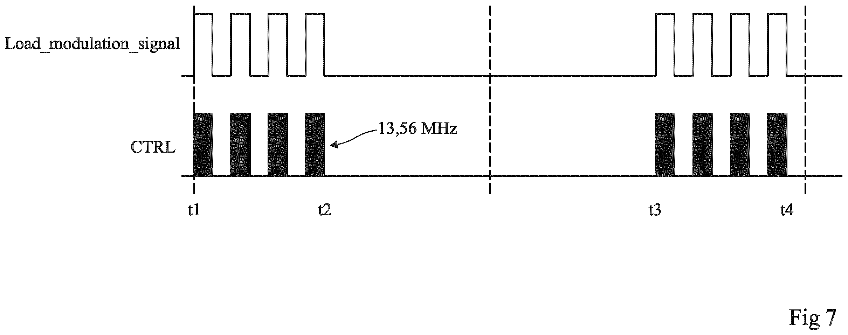

Figure 7 is another chronogram of functioning of a circuit of Figure 3. More precisely, Figure 6 represents the load modulation signal as function of time as well as the signal CTRL.

In the represented example, the load modulation signal is similar to Figure 6. The signal CTRL is pulsing at the carrier frequency 13,56MHz (represented in shaded area) during the pulses of the load modulation signal, and is off elsewhere. The push-pull stages of the radio frequency drivers 220,222 are driven during high state of the CTRL signal to achieve an active load modulation.

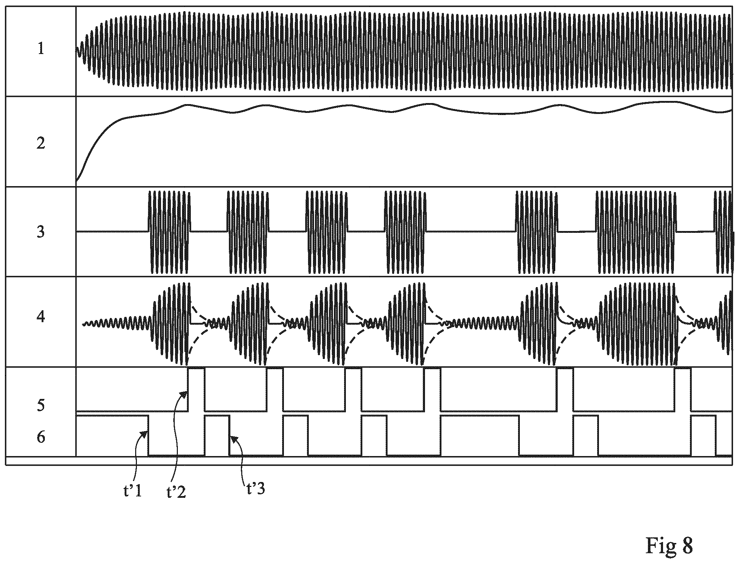

Figure 8 is another chronogram of functioning of a circuit of Figure 3. More precisely, the example of Figure 7 represents, during active load modulation, the reader 160 signal (line 1), the envelope of the reader signal of line 1 (line 2), the signal between nodes NRF01 and NRF02 (line 3), the signal between nodes Ant1 and Ant2 (line 4), the damping signal (line 5) and a phase locked loop signal.

Before a time t'1, the reader signal begins to be detected and the signals of lines 3, 4, 5 are at a low level, only the phase locked loop signal is at a high level.

At time t'1, the signal between nodes NRF01 and NRF02 oscillates at the carrier frequency during the duration of a pulse of the load modulation signal in order to a obtain a modulation on the reader signal until a time t'2. This modulation signal is present on the antenna outputs nodes Ant1, Ant2 with an amplitude growing shape until time t'2.

When the signal between nodes NRF01 and NRF02 is stopped at time t'2, the damping control signal pulse is enabled which allow to increase the decay speed of the output signal at the antenna outputs. Without the use of the damping control signal, the decay would take longer time as shown in dashed lines.

As soon as the damping control signal pulse is finished, the phase-locked loop signal is put back at a high state level until a modulation signal is enabled again at a high level at a time t'3. The process described from time t'1 to time t'3 is then repeated for each modulation. In the represented example seven subcarrier modulation periods are applied.

Other aspects of the present disclosure are summarized below.

According to an example 1 of a first aspect, an NFC controller 140 is configured to switch from active load modulation to passive load modulation when a battery power level is lower than a first power threshold or when an NFC charging session starts.

According to an example 2 of the first aspect, a method of operating an NFC controller (140) comprises the step of switching from active load modulation to passive load modulation at least when a battery power level is lower than a first power threshold or when an NFC charging session starts.

Example 3: The NFC controller of example 1, or the method of example 2, wherein the controller (140) switches from passive load modulation to active load modulation when a received signal strength indicator (RSSI) becomes higher than a first RSSI threshold.

Example 4: The NFC controller or the method of example 3, wherein the controller switches from active load modulation to passive load modulation when the received signal strength indicator becomes lower than a second RSSI threshold, the first RSSI threshold being higher than the second threshold.

Example 5: The NFC controller of any of examples 1 or 3 or 4, or the method of any of examples 2 to 4, wherein the controller switches from passive load modulation to active load modulation when the battery power level is higher than a second power threshold.

Example 6: The NFC controller or the method of examples 4 or 5, wherein the first and second RSSI thresholds are based on the modulation type.

Example 7: The NFC controller of any of examples 1, or 3 to 6, or the method of any of examples 2 to 6, wherein the switching is performed when the controller is in a card emulation mode.

Example 8: The controller or the method of any of examples 3, or 4 to 7 in their dependence to example 3, wherein the received signal strength indicator is filtered or averaged.

Example 9: The controller of any of examples 1, or 3 to 8, or the method of any of examples 2 to 8, wherein the controller (140) comprises at least one radio frequency driver (220,222) and, during passive load modulation, said radio frequency driver is configured to adopt a third or a fourth resistance value based on a load modulation signal level.

Example 10: The controller or the method of example 9, wherein the controller (140) comprises at least one resistive circuit (210,212) and, during passive load modulation, said resistive circuit is configured to adopt a first or a second resistance value based on the load modulation signal (Load_modulation_signal) level.

Example 11: The controller or the method of example 10, wherein said at least one resistive circuit (210) has a plurality of first branches (412...412n) in parallel each coupling ground (GND) to a same first node (CDMP1), each first branches comprising a first switch (424...424n) and a resistor (404...404n) ; and
- said at least one radio frequency driver (220,222) comprising a plurality of second branches (312...312n) coupling ground to a reference voltage rail (VDD,VDDRF), each of the second branches comprising:
   an NMOS and a PMOS transistors (P1...Pn,N1...Nn) in series, a conduction node of said NMOS transistor being coupled to ground and a conduction node of said PMOS transistor being coupled to the reference voltage rail, a conduction node common to said NMOS transistor and said PMOS transistor being coupled to a second node (NRF01,NRF02) ;
   a second switch (302...302n) configured to couple, in a first state, a controlling node of said PMOS transistor to the reference voltage rail (VDD) and, in a second state, the controlling node of said PMOS and NMOS transistors to a same third node (NCTRL _SEL1); and
   a third switch (304...304n) configured to couple, in a first state, a controlling node of said NMOS transistor to ground, and in a second state, the controlling node of said PMOS and NMOS transistors to the third node (NCTRL _SEL1), the first state of the second and third switches occurring at the same time, and the second state of the second and third switches occurring at the same time.

Example 12: The controller or the method of example 11, wherein the first and second resistance values correspond respectively to a first number of the first switches (424...424n) of the first branches (412...412n) being in a conductive state and to a second number of the first switches of the first branches being in a conductive state; the first switches of the resistive circuit being driven based on the load modulation signal level, a first load modulation signal level corresponding to said first number and a second load modulation signal level corresponding to said second number.

Example 13: The controller or the method of any of examples 10 to 12, wherein the third and fourth resistance values correspond respectively to a third and fourth numbers of the second or third switches of the second branches which are in the first state, the first load modulation signal level corresponding to said third number and the second load modulation signal level corresponding to said fourth number.

Example 14: The controller or the method of any of examples 9 to 13, wherein during active load modulation, the resistive circuit is configured to adopt, based on a damping signal (Damping_control) level:
a fifth resistance value adapted to lower a quality factor of an antenna (120) coupled to the controller; and
a sixth resistance value adapted to increase said quality factor;
said fifth and sixth resistance values corresponding to a respective fifth and sixth number of first switches (424...424n) of the first branches which are in a conductive state.

Example 15: The controller or the method of any of examples 10 to 14, wherein the controller comprises a first logic unit (250) configured to perform, during active load modulation, an AND logic function from an NFC carrier signal and the load modulation signal, to generate a control signal (CTRL) on the third node (NCTRL_SEL1).

Example 16: The controller or the method of example 15, wherein the load modulation signal (Load _modulation_signal) is a Manchester coded subcarrier of the NFC carrier signal.

Example 17: The controller or the method of any of examples 10 to 16, the NMOS or PMOS transistors of the second branches are binary weighted from one second branch to another and wherein the resistors (404...404n) of the first branches are binary weighted from one first branch (412...412n) to another.

Example 18: The controller or the method of any of examples 14 to 17, the first, second, third, fourth, fifth and sixth numbers are coded in one or several registers of a non-volatile memory (150).

Example 19: The controller or the method of any of examples 10 to 18, the controller comprises a first and a second of said at least one resistive circuits (RCDMP1,RCDMP2), and a first and a second of said at least one radio frequency driver (220,222);
the controller comprising a second logic unit (252) configured to perform, during active load modulation, an AND logic function from the inversed NFC carrier signal and the load modulation signal, to generate an inversed control signal (CTRL/) on the third node (NCTRL_SEL2) coupled to the second radio frequency driver.

According to an example 20, an NFC device (100) comprises:
- the NFC controller (140) of any of examples 1 or 3 to 19;
- an antenna (120); and
- a matching circuit (130) coupling the controller (140) to the antenna (120).

Example 21: The device of example 20 wherein the matching circuit comprises:
- a first and a second input nodes (CDMP1,CDMP2) coupled respectively to the first and second resistive circuits (210,212) of the controller;
- a third and fourth input nodes (NRF01,NRF02) coupled respectively to the first and the second radio frequency drivers (220,222) of the controller ;
- a first and a second output nodes (Ant1,Ant2) coupled to the antenna (120);
- a first and a second capacitance coupling respectively the first input node (CDMP1) to the first output node (Ant1) and the second input node (CDMP2) to the second output node (Ant2);
- a third capacitance (Cp) coupling the first output node to the second output node;
- a resistor (Rp) coupling the first output node (Ant1) to the second output node (Ant2);
- a first and a second inductances (Lemi1, Lemi2) coupling respectively the first radio frequency driver (220) to a fourth node (Nm4) and the second radio frequency driver (222) to a fifth node (Nm5);
- a fourth and a fifth capacitances (Cemi1,Cemi2) coupling respectively the fourth node (Nm4) and the fifth node (Nm5) to ground;
- a sixth and a seventh capacitances (Cs1,Cs2) coupling respectively the fourth node (Nm4) to the first output node (Ant1) and the fifth node (Nm5) to the second output node (Ant2).

According to an example 22 of a second aspect, an NFC device (100) comprises:
an NFC controller (140) comprising a first and second resistive circuits (210,212); and
a matching circuit (130) coupling the controller (140) to the antenna (120) and comprising:
   - a first and a second input nodes (CDMP1,CDMP2) coupled respectively to the first and second resistive circuits (210,212) of the controller;
   - a first and a second output nodes (Ant1,Ant2) configured to be coupled to an antenna;
   - a first and a second capacitance (Ccdmp1,Ccdmp2) coupling respectively the first input node (CDMP1) to the first output node (Ant1) and the second input node (CDMP2) to the second output node (Ant2).

Example 23: The NFC device of example 22, wherein the NFC controller (140) is configured to switch from active load modulation to passive load modulation at least when a battery power level is lower than a first power threshold or when an NFC charging session starts.

Example 24: The NFC device of example 22 or 23, wherein the controller (140) switches from passive load modulation to active load modulation when a received signal strength indicator (RSSI) becomes higher than a first RSSI threshold.

Example 25: The NFC device of example 23 or 24, wherein the controller switches from active load modulation to passive load modulation when the received signal strength indicator becomes lower than a second RSSI threshold, the first RSSI threshold being higher than the second threshold.

Example 26: The NFC device of any of examples 23, or 24 or 25 in their dependence to example 23, wherein the controller switches from passive load modulation to active load modulation when the battery power level is higher than a second power threshold.

Example 26: The NFC device of example 25, wherein the first and second RSSI thresholds are based on the modulation type.

Example 27: The NFC device of any of examples 23 to 26, wherein the switching is performed when the controller is in a card emulation mode.

Example 28: The NFC device of any of examples 24, or 25 to 27 in their dependence to example 24, wherein the received signal strength indicator is filtered or averaged.

Example 29: The NFC device of any of examples 23 to 28, wherein during passive load modulation, said resistive circuit is configured to adopt a first or a second resistance value based on a load modulation signal (Load _modulation_signal) level.

Example 30: The NFC device of any of examples 23 to 29, wherein the controller (140) comprises at least one radio frequency driver (220,222) and, during passive load modulation, said radio frequency driver is configured to adopt a third or a fourth resistance value based on the load modulation signal level.

Example 31: The NFC device of example 30 in its dependence to example 29, wherein said resistive circuit (210) has a plurality of first branches (412...412n) in parallel each coupling ground (GND) to the same first node (CDMP1), each first branches comprising a first switch (424...424n) and a resistor (404...404n) ; and
- said at least one radio frequency driver (220,222) comprising a plurality of second branches (312...312n) coupling ground to a reference voltage rail (VDD,VDDRF), each of the second branches comprising:
   an NMOS and a PMOS transistors (P1...Pn,N1...Nn) in series, a conduction node of said NMOS transistor being coupled to ground and a conduction node of said PMOS transistor being coupled to the reference voltage rail, a conduction node common to said NMOS transistor and said PMOS transistor being coupled to a second node (NRF01,NRF02) ;
   a second switch (302...302n) configured to couple, in a first state, a controlling node of said PMOS transistor to the reference voltage rail (VDD) and, in a second state, the controlling node of said PMOS and NMOS transistors to a same third node (NCTRL _SEL1); and
   a third switch (304...304n) configured to couple, in a first state, a controlling node of said NMOS transistor to ground, and in a second state, the controlling node of said PMOS and NMOS transistors to the third node (NCTRL_SEL1), the first state of the second and third switches occurring at the same time, and the second state of the second and third switches occurring at the same time.

Example 32: The NFC device of any of examples 29 to 31, wherein the first and second resistance values correspond respectively to a first number of the first switches (424...424n) of the first branches (412...412n) being in a conductive state and to a second number of the first switches of the first branches being in a conductive state; the first switches of the resistive circuit being driven based on the load modulation signal level, a first load modulation signal level corresponding to said first number and a second load modulation signal level corresponding to said second number.

Example 33: The NFC device of any of examples 29 to 32, wherein the third and fourth resistance values correspond respectively to a third and fourth numbers of the second or third switches of the second branches which are in the first state, the first load modulation signal level corresponding to said third number and the second load modulation signal level corresponding to said fourth number.

Example 34: The NFC device of any of examples 29 to 33, wherein during active load modulation, the resistive circuit is configured to adopt, based on a damping signal (Damping_control) level:
a fifth resistance value adapted to lower a quality factor of an antenna (120) coupled to the controller; and
a sixth resistance value adapted to increase said quality factor;
said fifth and sixth resistance values corresponding to a respective fifth and sixth number of first switches (424...424n) of the first branches which are in a conductive state.

Example 35: of any of examples 29 to 34, the controller comprises a first logic unit (250) configured to perform, during active load modulation, an AND logic function from an NFC carrier signal and the load modulation signal, to generate a control signal (CTRL) on the third node (NCTRL_SEL1).

Example 36: The NFC device of example 35, the load modulation signal (Load_modulation_signal) is a Manchester coded subcarrier of the NFC carrier signal.

Example 37: The NFC device of any of examples 29 to 36, the NMOS or PMOS transistors of the second branches are binary weighted from one second branch to another and wherein the resistors (404...404n) of the first branches are binary weighted from one first branch (412...412n) to another.

Example 38: The NFC device of any of examples 33 to 37, the first, second, third, fourth, fifth and sixth numbers are coded in one or several registers of a non-volatile memory (150).

Example 39: The NFC device of any of examples 29 to 38, the controller (140) comprises a first and a second radio frequency drivers (220,222), and the matching circuit comprises:
- a third and fourth input nodes (NRF01,NRF02) coupled respectively to the first and the second radio frequency drivers (220,222) of the controller;
- a third capacitance (Cp) coupling the first output node to the second output node a resistor (Rp) coupling the first output node (Ant1) to the second output node (Ant2);
- a first and a second inductances (Lemi1, Lemi2) coupling respectively the first radio frequency driver (220) to a fourth node (Nm4) and the second radio frequency driver (222) to a fifth node (Nm5);
- a fourth and a fifth capacitances (Cemi1,Cemi2) coupling respectively the fourth node (Nm4) and the fifth node (Nm5) to ground; and
- a sixth and a seventh capacitances (Cs1,Cs2) coupling respectively the fourth node (Nm4) to the first output node (Ant1) and the fifth node (Nm5) to the second output node (Ant2)

Various embodiments and variants have been described. Those skilled in the art will understand that certain features of these embodiments can be combined and other variants will readily occur to those skilled in the art. In particular, even if the example of Figure 2 describes two resistive circuits and two radio frequency drivers, a controller 140 having one resistive circuit and one radio frequency driver can be envisaged. In that case, nodes NRF01 and NRF02 can be connected together and are in phase.

Finally, the practical implementation of the embodiments and variants described herein is within the capabilities of those skilled in the art based on the functional description provided hereinabove. In particular, concerning the number of resistances values, the person of the art may use its knowledge to predefine more than two different resistances values possible for the resistive circuits or for the radio frequency drivers depending on the passive or active load modulations needs.

## Claims

1. An NFC controller (140) configured to switch from active load modulation to passive load modulation at least when a received signal strength indicator (RSSI) becomes higher than a first RSSI threshold.

2. A method of operating an NFC controller (140), comprising the step of switching from active load modulation to passive load modulation at least when a received signal strength indicator (RSSI) becomes higher than a first RSSI threshold.

3. The controller of claim 1 or the method of claim 2, wherein the controller (140) switches from passive load modulation to active load modulation when a battery power level is lower than a first power threshold or when an NFC charging session starts.

4. The controller or the method of claim 1 or 3, wherein the controller switches from active load modulation to passive load modulation when the received signal strength indicator becomes lower than a second RSSI threshold, the first RSSI threshold being higher than the second threshold.

5. The controller, or the method of claim 3 or 4, wherein the controller switches from passive load modulation to active load modulation when the battery power level is higher than a second power threshold.

6. The controller or the method of claims 4 or 5, wherein the first and second RSSI thresholds are based on the modulation type.

7. The controller of any of claims 1 or 3 or 6, or the method of any of claims 2 to 6, wherein the switching is performed when the controller is in a card emulation mode.

8. The controller 1 or 3 to 7, or the method of any of claims 2 to 7, wherein the received signal strength indicator is filtered or averaged.

9. The controller of any of claims 1 or 3 to 8, or the method of any of claims 2 to 8, wherein the controller (140) comprises at least one radio frequency driver (220,222) and, during passive load modulation, said radio frequency driver is configured to adopt a third or a fourth resistance value based on a load modulation signal level.

10. The controller or the method of claim 9, wherein the controller (140) comprises at least one resistive circuit (210,212) and, during passive load modulation, said resistive circuit is configured to adopt a first or a second resistance value based on the load modulation signal (Load_modulation_signal) level.

11. The controller or the method of claim 10, wherein said at least one resistive circuit (210) has a plurality of first branches (412...412n) in parallel each coupling ground (GND) to a same first node (CDMP1), each first branches comprising a first switch (424...424n) and a resistor (404...404n) ; and
- said at least one radio frequency driver (220,222) comprising a plurality of second branches (312...312n) coupling ground to a reference voltage rail (VDD,VDDRF), each of the second branches comprising:
an NMOS and a PMOS transistors (P1...Pn,N1...Nn) in series, a conduction node of said NMOS transistor being coupled to ground and a conduction node of said PMOS transistor being coupled to the reference voltage rail, a conduction node common to said NMOS transistor and said PMOS transistor being coupled to a second node (NRF01,NRF02) ;
a second switch (302...302n) configured to couple, in a first state, a controlling node of said PMOS transistor to the reference voltage rail (VDD) and, in a second state, the controlling node of said PMOS and NMOS transistors to a same third node (NCTRL _SEL1); and
a third switch (304...304n) configured to couple, in a first state, a controlling node of said NMOS transistor to ground, and in a second state, the controlling node of said PMOS and NMOS transistors to the third node (NCTRL_SEL1), the first state of the second and third switches occurring at the same time, and the second state of the second and third switches occurring at the same time.

12. The controller or the method of any of claim 11, wherein the first and second resistance values correspond respectively to a first number of the first switches (424...424n) of the first branches (412...412n) being in a conductive state and to a second number of the first switches of the first branches being in a conductive state; the first switches of the resistive circuit being driven based on the load modulation signal level, a first load modulation signal level corresponding to said first number and a second load modulation signal level corresponding to said second number.

13. The controller or the method of any of claims 11 or 12, wherein the third and fourth resistance values correspond respectively to a third and fourth numbers of the second or third switches of the second branches which are in the first state, the first load modulation signal level corresponding to said third number and the second load modulation signal level corresponding to said fourth number.

14. The controller or the method of any of claims 11 to 13, wherein, during active load modulation, the resistive circuit is configured to adopt, based on a damping signal (Damping_control) level:
a fifth resistance value adapted to lower a quality factor of an antenna (120) coupled to the controller; and
a sixth resistance value adapted to increase said quality factor;
said fifth and sixth resistance values corresponding to a respective fifth and sixth number of first switches (424...424n) of the first branches which are in a conductive state.

15. The controller or the method of any of claims 11 to 14, wherein the controller comprises a first logic unit (250) configured to perform, during active load modulation, an AND logic function from an NFC carrier signal and the load modulation signal, to generate a control signal (CTRL) on the third node (NCTRL_SEL1).

16. The controller or the method of claim 15, wherein the load modulation signal (Load_modulation_signal) is a Manchester coded subcarrier of the NFC carrier signal.

17. The controller or the method of any of claims 11 to 16, wherein the NMOS or PMOS transistors of the second branches are binary weighted from one second branch to another and wherein the resistors (404...404n) of the first branches are binary weighted from one first branch (412...412n) to another.

18. The controller or the method of any of claims 14 to 17, wherein the first, second, third, fourth, fifth and sixth numbers are coded in one or several registers of a non-volatile memory (150).

19. The controller or the method of any of claim 11 to 18 wherein the controller comprises a first and a second of said at least one resistive circuits (RCDMP1,RCDMP2), and a first and a second of said at least one radio frequency driver (220,222);
the controller comprising a second logic unit (252) configured to perform, during active load modulation, an AND logic function from the inversed NFC carrier signal and the load modulation signal, to generate an inversed control signal (CTRL/) on the third node (NCTRL_SEL2) coupled to the second radio frequency driver.

20. NFC device (100) comprising:
- the NFC controller (140) of any of claims 1 or 3 to 19;
- an antenna (120); and
- a matching circuit (130) coupling the controller (140) to the antenna (120).

21. The device of claim 20 in its dependence to claim 19, wherein the matching circuit comprises:
- a first and a second input nodes (CDMP1,CDMP2) coupled respectively to the first and second resistive circuits (210,212) of the controller;
- a third and fourth input nodes (NRF01,NRF02) coupled respectively to the first and the second radio frequency drivers (220,222) of the controller ;
- a first and a second output nodes (Ant1,Ant2) coupled to the antenna (120);
- a first and a second capacitance (Ccdmp1,Ccdmp2) coupling respectively the first input node (CDMP1) to the first output node (Ant1) and the second input node (CDMP2) to the second output node (Ant2);
- a third capacitance (Cp) coupling the first output node to the second output node;
- a resistor (Rp) coupling the first output node (Ant1) to the second output node (Ant2);
- a first and a second inductances (Lemi1, Lemi2) coupling respectively the first radio frequency driver (220) to a fourth node (Nm4) and the second radio frequency driver (222) to a fifth node (Nm5);
- a fourth and a fifth capacitances (Cemi1,Cemi2) coupling respectively the fourth node (Nm4) and the fifth node (Nm5) to ground;
- a sixth and a seventh capacitances (Cs1,Cs2) coupling respectively the fourth node (Nm4) to the first output node (Ant1) and the fifth node (Nm5) to the second output node (Ant2).
